# EUROPEAN PATENT APPLICATION

(11) **EP 4 686 522 A1**
(43) Date of publication of application: **04.02.2026**
(21) Application number: 25193303.2
(22) Date of filing: 31.07.2025
(51) Int. Cl.: B23K 1/00, B23K 1/008, B23K 37/047, B65G 47/66

(54) **APPARATUS FOR JOINING ELECTRONIC COMPONENTS TO ELECTRONIC SUBSTRATE**

(30) Priority: 02.08.2024 CN 202411056565; 28.07.2025 CN 202511044406
(71) Applicant: Illinois Tool Works Inc., Glenview IL 60025 (US)
(72) Inventor: YAN, Shenghu, Glenview, 60025 (US)
(74) Representative: HGF

(57) **Abstract**

The present disclosure provides an apparatus for joining electronic components to an electronic substrate including a frame, a first conveyor section and a second conveyor section, and a support device. The first and second conveyor sections are supported by the frame and arranged spaced apart from each other along a conveying direction of the electronic substrate, and the first and second conveyor sections have first and second conveying surfaces, respectively. A receiving area is provided between the first and second conveyor sections. The support device is coupled to the frame and movable between a supporting position and a rest position relative to the first conveyor section and the second conveyor section. The support device has a supporting surface. In the supporting position, the support device is at least partially located and held in the receiving area and the supporting surface is substantially flush with the first conveying surface and the second conveying surface. In the rest position, the support device exits the receiving area. Since the support device of the present disclosure can provide support when the electronic substrate is conveyed between the adjacent conveyor sections, the stability of conveying of the electronic substrate can be improved.

## Description

### CROSS-REFERENCE TO RELATED APPLICATIONS

The present disclosure claims priority to Chinese Patent Application No. 2024110565651, filed August 2, 2024 and entitled "CONVEYOR AND REFLOW SOLDERING OVEN COMPRISING SAME", which is incorporated herein by reference in its entirety.

### TECHNICAL FIELD

The present disclosure relates to an apparatus for connecting electronic components to an electronic substrate, for example, a reflow soldering oven.

### BACKGROUND

During the manufacturing of a printed circuit board, electronic elements are mounted to an electronic substrate usually by using a process referred to as "reflow soldering". In the reflow soldering process, a soldering paste (such as solder paste), is deposited onto a selected area of the electronic substrate and wires of one or more electronic elements are inserted into the deposited soldering paste. A conveyor then carries and conveys the electronic substrate through a hearth of the reflow soldering oven. In the hearth of the reflow soldering oven, the soldering paste reflows in a heating area (i.e. heated to a melting or reflow temperature), then is cooled in a cooling area, so as to electrically and mechanically connect the wires of the electronic elements to the electronic substrate. As used herein, the term "electronic substrate" includes a substrate assembly for any type of electronic elements, including, for example, a wafer substrate.

Some reflow soldering ovens include vacuum a treatment zone in which vacuum treatment environment is provided, and the electronic substrate is soldered in the vacuum treatment environment to improve the quality of soldered surfaces.

### SUMMARY OF THE DISCLOSURE

The inventor of the present application discovered through prolonged observation and research that in prior art, when a reflow soldering oven having a vacuum treatment zone conveys electronic substrates into and out of the vacuum treatment zone, the spacing between the conveyor section within the vacuum treatment zone and the conveyor section outside the vacuum treatment zone results in conveying instability of the electronic substrates.

To at least partially solve the above problem, according to a first aspect of the present disclosure, the present disclosure provides an apparatus for joining electronic components to an electronic substrate. The apparatus includes a frame, a first conveyor section and a second conveyor section, and a support device. The first conveyor section and the second conveyor section are supported by the frame and arranged spaced apart from each other along a conveying direction of the electronic substrate, and the first conveyor section and the second conveyor section have a first conveying surface and a second conveying surface, respectively. A receiving area is provided between the first conveyor section and the second conveyor section. The support device is coupled to the frame and movable between a supporting position and a rest position relative to the first conveyor section and the second conveyor section. The support device has a supporting surface. In the supporting position, the support device is at least partially located and held in the receiving area and the supporting surface is substantially flush with the first conveying surface and the second conveying surface. In the rest position, the support device exits the receiving area.

In some embodiments, the support device includes a support block rotatably coupled to the frame and a support roller rotatably connected to the support block, and the supporting surface is formed by the support roller.

In some embodiments, the apparatus further includes a stop structure provided on the frame and above the support block. When the support block is rotated to the supporting position, the support block is stopped by the stop structure.

In some embodiments, the apparatus further includes a drive device configured to drive the support device to move from the rest position to the supporting position, maintain the support device in the supporting position and allow the support device to move from the supporting position to the rest position.

In some embodiments, the drive device provides a linear driving force and includes an output end. The apparatus further includes a push rod connected to the output end of the drive device and configured to travel forward and backward under the drive of the drive device. When the push rod travels forward, the push rod pushes the support device to rotate from the rest position to the supporting position, and when the push rod travels backward, the push rod allows the support device to rotate from the supporting position to the rest position.

In some embodiments, the frame includes a first transverse beam section and a second transverse beam section arranged spaced apart from each other along the conveying direction of the electronic substrate and supporting the first conveyor section and the second conveyor section, respectively.

In some embodiments, the apparatus further includes a bridging device comprising a bridging rod and a receiving structure. The bridging rod is connected to the output end of the drive device and configured to travel forward and backward under the drive of the drive device, and the receiving structure is disposed at the second transverse beam section and configured to receive the bridging rod.

In some embodiments, the frame includes a mounting base to which the support block is rotatably connected, the stop structure being provided on the mounting base. The mounting base is provided with a first guide hole and a second guide hole receiving the push rod and the bridging rod, respectively, and guiding the push rod and the bridging rod to travel forward and backward in the conveying direction.

In some embodiments, the apparatus further includes an additional support structure having an additional supporting surface. When the support device is in the supporting position, the additional supporting surface is located between the supporting surface of the support device and the first conveying surface or the second conveying surface, and the additional supporting surface is substantially flush with the supporting surface.

In some embodiments, the additional support structure includes an additional support roller rotatably coupled to the frame, and the additional supporting surface is formed by the additional support roller; or the additional support structure includes a supporting flange provided on a side of the frame, and the additional supporting surface is formed by the supporting flange.

In some embodiments, the drive device includes a cylinder.

In some embodiments, the drive device includes an elastic device.

In some embodiments, the apparatus is a reflow soldering oven.

According to a second aspect of the present disclosure, the present disclosure provides an apparatus for joining electronic components to an electronic substrate. The apparatus includes a frame, a vacuum treatment zone, a second conveyor section and a support device. The vacuum treatment zone includes a base supported by the frame; a first conveyor section supported by the frame and having a first conveying surface; and a cover having a side wall and having a closed state and an open state. The second conveyor section is supported by the frame and arranged spaced apart from the first conveyor section along a conveying direction of the electronic substrate, and the second conveyor section has a second conveying surface. A receiving area is provided between the first conveyor section and the second conveyor section. The support device is coupled to the frame and movable between a supporting position and a rest position relative to the first conveyor section and the second conveyor section. The support device has a supporting surface. When the vacuum treatment zone is activated, the cover is in the closed state, the support device is in the rest position, the side wall of the cover is located in the receiving area and engaged with the base to form a chamber between the cover and the base, and the first conveyor section is accommodated in the chamber. When the electronic substrate is conveyed between the vacuum treatment zone and the second conveyor section, the cover is in the open state, the support device is in the supporting position, the side wall of the cover exits the receiving area while the support device is at least partially located and held in the receiving area, and the supporting surface is substantially flush with the first conveying surface and the second conveying surface, such that the electronic substrate is at least partially supported by the supporting surface as the electronic substrate is conveyed between the first conveying surface and the second conveying surface.

In some embodiments, the support device includes a support block rotatably coupled to the frame and a support roller rotatably connected to the support block, and the supporting surface is formed by the support roller.

In some embodiments, the apparatus further includes a stop structure provided on the frame and above the support block. When the support block is rotated to the supporting position, the support block is stopped by the stop structure.

In some embodiments, the apparatus further includes a drive device configured to drive the support device to move from the rest position to the supporting position, maintain the support device in the supporting position and allow the support device to move from the supporting position to the rest position.

In some embodiments, the drive device provides a linear driving force and includes an output end. The apparatus further includes a push rod connected to the output end of the drive device and configured to travel forward and backward under the drive of the drive device. When the push rod travels forward, the push rod pushes the support device to rotate from the rest position to the supporting position, and when the push rod travels backward, the push rod allows the support device to rotate from the supporting position to the rest position.

In some embodiments, the drive device includes a cylinder.

In some embodiments, the drive device includes an elastic device.

In some embodiments, the apparatus is a reflow soldering oven.

According to the reflow soldering oven of the present disclosure, the movable support device is provided and is allowed to enter and exit the receiving area between the adjacent conveyor sections for the cover, such that when it is desired to mount the cover between the adjacent conveyor sections, the support device can exit the receiving area between the conveyor sections to allow the cover to enter the receiving area, and when it is desired to convey the electronic substrate between adjacent conveyor sections, the support device can enter the receiving area between the conveyor sections to support the electronic substrate by its supporting surface. The stability of conveying of the electronic substrate can be improved because the support device can provide support when the electronic substrate is conveyed between the adjacent conveyor sections.

### BRIEF DESCRIPTION OF THE DRAWINGS

Fig. 1A is a perspective view of a reflow soldering oven according to a first embodiment of the present disclosure;
Fig. 1B is a partially exploded view of the reflow soldering oven shown in Fig. 1A;
Fig. 2 is a partially enlarged side view of the reflow soldering oven shown in Fig. 1B;
Fig. 3A is a partial perspective view of adjacent portions of a first conveyor section and a second conveyor section of the reflow soldering oven shown in Fig. 2;
Fig. 3B is a partial perspective view of adjacent portions of the first conveyor section and the second conveyor section of the reflow soldering oven shown in Fig. 3A from another perspective;
Fig. 4A is an assembled perspective view of a support device and associated components of the reflow soldering oven shown in Fig. 3A;
Fig. 4B is an assembled perspective view of the support device and the associated components shown in Fig. 3A from another perspective;
Fig. 4C is an exploded view of the support device and the associated components shown in Fig. 3A;
Fig. 5A is a side view of the support device of the reflow soldering oven shown in Fig. 2 in a rest position;
Fig. 5B is a side view of the support device rotated a distance from the rest position shown in Fig. 5A;
Fig. 5C is a side view of the support device of the reflow soldering oven shown in Fig. 5A in a supporting position;
Fig. 6A is a perspective view of a support device and associated components of a reflow soldering oven according to a second embodiment of the present disclosure; and
Fig. 6B is a perspective view of the support device and associated components shown in Figure 6A from another perspective.

### Main reference numerals

Frame 1; First transverse beam section 11; Second transverse beam section 12; Mounting base 15; Stop structure 151; Mounting base body 152; First guide hole 153; Second guide hole 154; Lateral additional block 155; Rod connecting block 156; Fastener 157; Accommodating portion 159; Conveying line 2, 2'; First conveyor section 21; First conveying surface 211; Second conveyor section 22; Second conveying surface 221; Third conveyor section 23; Third conveying surface 231; Receiving area 25; Receiving area 26; Support device 3; Supporting surface 31; Support block 32; Support roller 33; Drive device 5; Output end 55; Elastic device 57; Push rod 6; Bridging device 7; Bridging rod 71; Receiving structure 72; Receiving hole 721; Additional support structure 8; Additional supporting surface 81; Supporting flange 83; Additional support roller 82; Vacuum treatment zone 9; Base 91; Cover 92; Top 921; Side wall 922; Chamber 93.

### DETAILED DESCRIPTION OF EMBODIMENTS

Various specific embodiments of the present disclosure will be described below with reference to the drawings which form part of this specification. It should be understood that although the terms indicating directions, such as "front", "rear", "upper", "lower", "left", "right", "top", and "bottom" are used in the present disclosure to describe structural parts and elements in various examples of the present disclosure, these terms are used herein only for ease of illustration and are determined based on the exemplary orientations shown in the accompanying drawings. Since the arrangements in the embodiments disclosed in the present disclosure may be in various directions, these terms indicating directions are only illustrative and should not be considered as limitations.

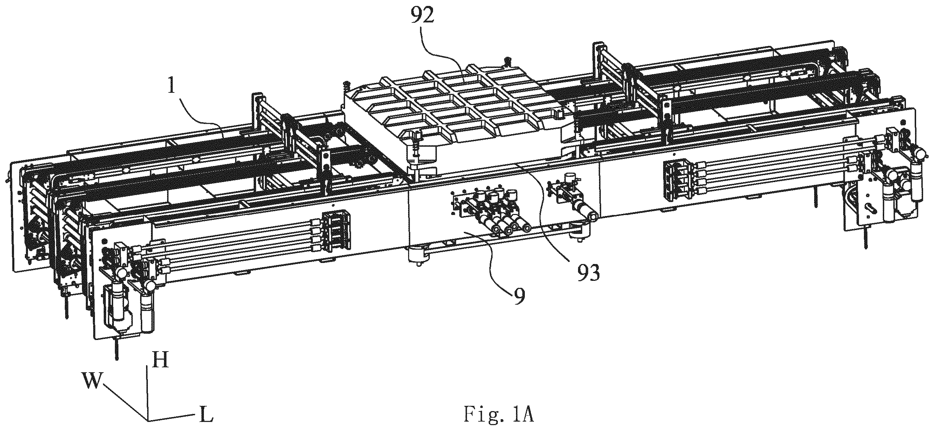

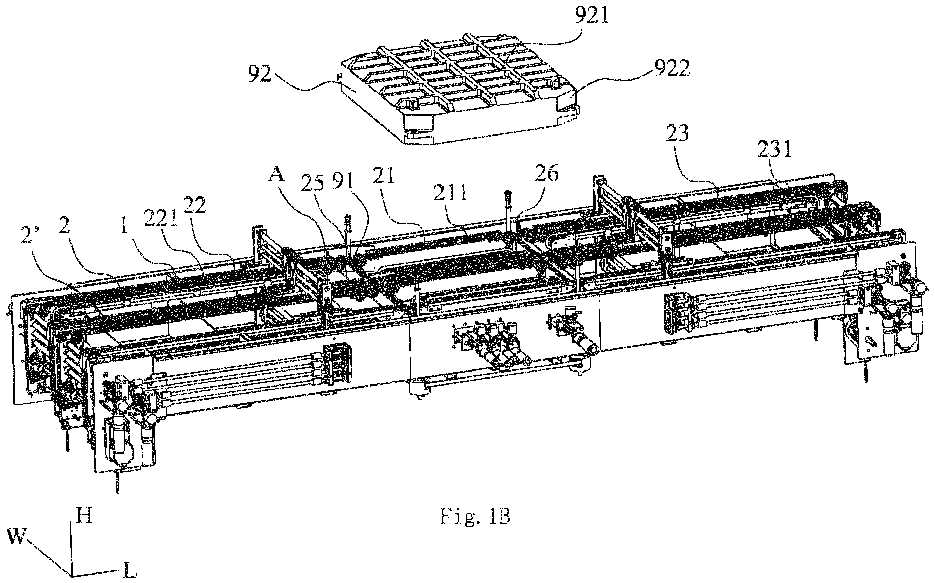

A reflow soldering oven according to the present disclosure is also referred to as "an apparatus for joining electronic components to an electronic substrate". Fig. 1A is a perspective view of a reflow soldering oven according to a first embodiment of the present disclosure, and Fig. 1B is a partially exploded view of the reflow soldering oven shown in Fig. 1A. For ease of illustration, a hood of the reflow soldering oven is not shown.

As shown in Figs. 1A and 1B, the reflow soldering oven has a length direction L, a width direction W, and a height direction H. The reflow soldering oven includes a frame 1 on which a conveying device is provided for conveying the electronic substrate along the length direction L. The reflow soldering oven includes a vacuum treatment zone 9 on the frame 1 and other treatment zones located upstream and downstream of the vacuum treatment zone 9 in the length direction L. The vacuum treatment zone 9 includes a base 91 (shown in Fig. 1B) and a cover 92, where the cover 92 can cover the base 91, and forms a closed chamber together with the base 91, so as to be able to create vacuum environment within the chamber. After the electronic substrate is conveyed into the vacuum treatment zone 9 by the conveying device, the vacuum treatment is carried out in the vacuum treatment zone 9, and after the vacuum treatment is completed, the electronic substrate is conveyed out of the vacuum treatment zone 9 by the conveying device. The cover 92 is movable relative to the base 91 to open or close the chamber of the vacuum treatment zone 9, and when the cover 92 is opened, the electronic substrate can be conveyed into and out of the vacuum treatment zone 9.

As shown in Fig. 1B, in the illustrated embodiment, the conveying device includes two conveying lines 2 and 2', where the two conveying lines 2 and 2' are arranged side by side in the width direction W of the reflow soldering oven, to convey two sets of electronic substrates simultaneously. The two conveying lines 2 and 2' are of the same structure. Each of the conveying lines 2 and 2' includes a pair of conveyor assemblies arranged side by side in the width direction W of the reflow soldering oven and supported by the frame 1. Each conveyor assembly includes a first conveyor section 21, a second conveyor section 22, and a third conveyor section 23, where the first conveyor section 21 is located between the second conveyor section 22 and the third conveyor section 23 in the length direction L. The first conveyor section 21 is located in the vacuum treatment zone 9. The first conveyor section 21, the second conveyor section 22 and the third conveyor section 23 have a first conveying surface 211, a second conveying surface 221 and a third conveying surface 231, respectively. The first conveying surface 211, the second conveying surface 221 and the third conveying surface 231 are at the same level in the height direction H, such that the electronic substrate can be conveyed between the first conveyor section 21 and the second conveyor section 22 and between the first conveyor section 21 and the third conveyor section 23. A spacing is provided between the first conveyor section 21 and the second conveyor section 22 such that a receiving area 25 can be formed therebetween. A spacing is provided between the second conveyor section 22 and the third conveyor section 23 such that a receiving area 26 can be formed therebetween.

In some embodiments, the second conveyor section 22 is located upstream of the first conveyor section 21 and the third conveyor section 23 is located downstream of the first conveyor section 21, thus the electronic substrate may be conveyed from the second conveyor section 22 to the first conveyor section 21 and then to the third conveyor section 23. In other embodiments, the electronic substrate is conveyed in an opposite direction, the third conveyor section 23 is located upstream of the first conveyor section 21 and the second conveyor section 22 is located downstream of the first conveyor section 21.

In some embodiments, the vacuum treatment zone 9 may be disposed at an end of the conveying line, the conveyor assembly includes only a first conveyor section 21 located in the vacuum treatment zone 9 and a second conveyor section 22 located on a side of the vacuum treatment zone 9.

The first conveyor section 21, the second conveyor section 22 and the third conveyor section 23 are, for example, independent conveyor belts driven by different pulleys.

As shown in Fig. 1B, the cover 92 includes a top 921 and a side wall 922, where the side wall 922 extend from a peripheral edge of the top 921 to enclose, together with the top 921, an upper accommodating cavity that has an opening. The base 91 of the reflow soldering oven has a bottom and a side wall and encloses a lower accommodating cavity. The side wall 922 of the cover 92 can engage with the side wall of the base 91 to collectively enclose a chamber 93. In some embodiments, the base 91 may also have no side wall, where the side wall 922 of the cover 92 engage with the bottom of the base 91 to enclose the chamber 93.

At the vacuum treatment zone 9, the base 91 is located below the first conveying surface 211, and the cover 92 is configured to be movable relative to the base 91 between an open state and a closed state. When the cover 92 is in the closed state, the side wall 922 of the cover 92 enter the receiving areas 25 and 26 and engage with the base 91 to form the chamber 93. In this case, the side wall 922 of the cover 92 is between the first conveyor section 21 and second conveyor section 22 and between the first conveyor section 21 and third conveyor section 23, so the electronic substrate is stopped by the side wall 922 of the cover 92 and cannot be conveyed through the receiving areas 25 and 26. When the cover 92 is in the open state, the side wall 922 of the cover 92 exits the receiving areas 25 and 26, such that the electronic substrate can be conveyed between the first conveyor section 21 and the second conveyor section 22 and between the first conveyor section 21 and the third conveyor section 23.

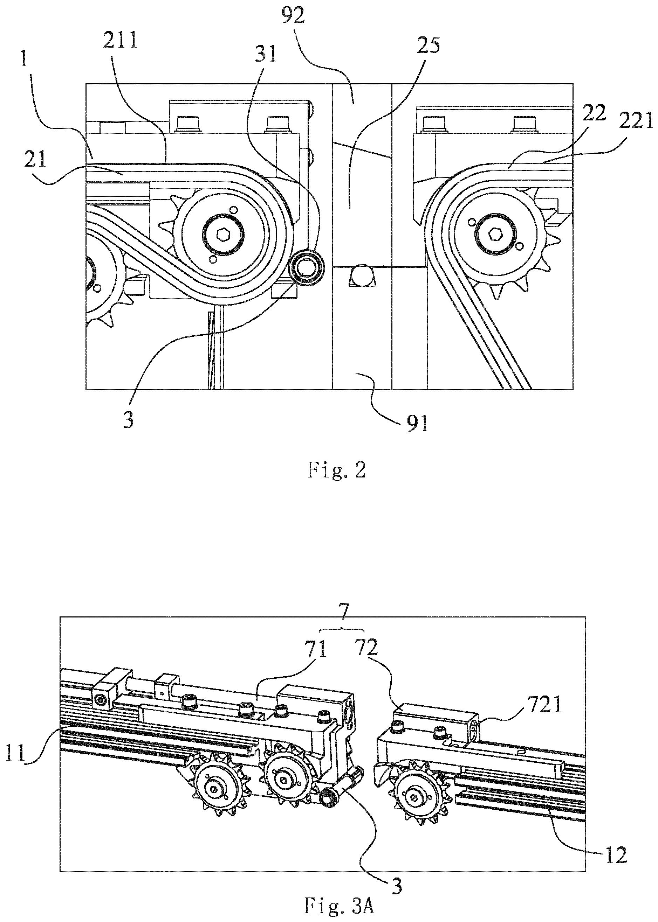

The reflow soldering oven of the present disclosure further includes a support device 3 (as shown in Fig. 2) for at least partially filling an area between adjacent conveyor sections which area is for receiving the side wall of the cover when conveying the electronic substrate, and for exiting the area between the adjacent conveyor sections which area is for receiving the side wall of the cover when it is desired to close the cover, so as to allow the side wall of the cover to enter the area. The support device of the present disclosure may be disposed at the first conveyor section 21 of the vacuum area 9 and the second conveyor section 22 adjacent thereto, or at the first conveyor section 21 and the third conveyor section 23 adjacent thereto. The support device is described below with an example in which the support device is disposed at the first conveyor section 21 and the second conveyor section 22.

Fig. 2 is a partial enlarged side view of part A of Fig. 1B. As shown in Fig. 2, the reflow soldering oven includes the support device 3 coupled to the frame 1, and the support device 3 has a supporting surface 31. The support device 3 is disposed at the first conveyor section 21, can enter and exit the receiving area 25 between the first conveyor section 21 and the second conveyor section 22, and have a supporting position and a rest position. When the support device 3 is in its supporting position, the support device 3 enters the receiving area 25 and the supporting surface 31 is substantially flush with the first conveying surface 211 and the second conveying surface 221. When the support device 3 is in its rest position, the support device 3 exits the receiving area 25 such that the cover 92 can enter the receiving area 25 and cover the base 91. In some embodiments of the present disclosure, the receiving area 25 is defined by a movement trajectory of the cover 92 between the first conveyor section 21 and the second conveyor section 22, and the spacing between the first conveyor section 21 and the second conveyor section 22 may be slightly larger than the receiving area 25. The support device 3 supports the electronic substrate when the electronic substrate is conveyed between the first conveyor section 21 and the second conveyor section 22, preventing tilting of the electronic substrate.

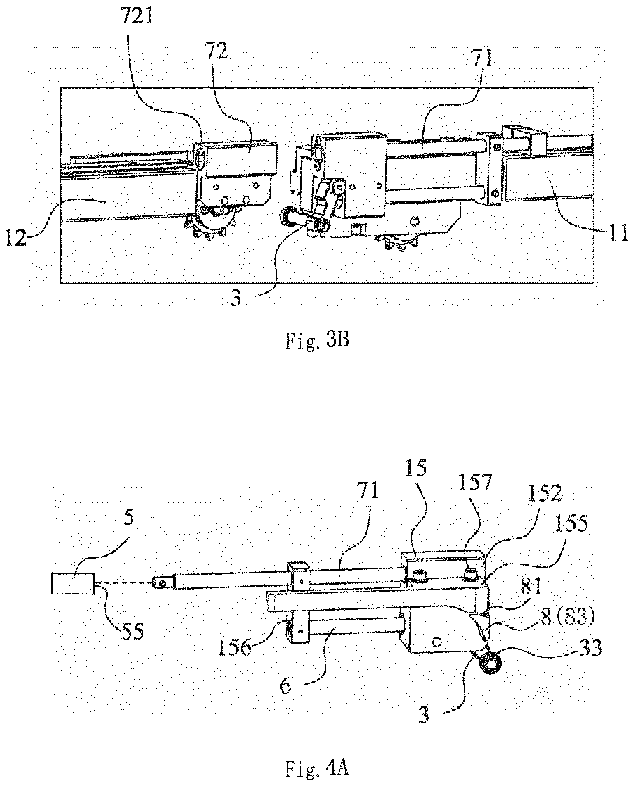

Fig. 3A is a partial perspective view of elements at adjacent area of the first conveyor section 21 and the second conveyor section 22 of the reflow soldering oven shown in Fig. 2, and Fig. 3B is a partial perspective view of the elements at the adjacent areas of the first conveyor section 21 and the second conveyor section 22 of the reflow soldering oven from another perspective. The first conveyor section 21 and the second conveyor section 22 are not shown in Figs. 3A and 3B for ease of illustration.

As shown in Figs. 3A and 3B, in order to allow the cover to be closed, the frame 1 includes a first transverse beam section 11 and a second transverse beam section 12 spaced apart from each other. The first transverse beam section 11 and the second transverse beam section 12 are arranged spaced apart from each other along the length direction L of the reflow soldering oven and support the first conveyor section 21 and the second conveyor section 22 shown in Fig. 2, respectively. A spacing between the first transverse beam section 11 and the second transverse beam section 12 is aligned with the spacing between the first conveyor section 21 and the second conveyor section 22, and when the cover 92 is closed, the side wall 922 of the cover 92 also enters the spacing between the first transverse beam section 11 and the second transverse beam section 12.

The reflow soldering oven is further provided with a bridging device 7 for bridging the first transverse beam section 11 and the second transverse beam section 12. The bridging device 7 includes a bridging rod 71 disposed at the first transverse beam section 11 and a receiving structure 72 provided at the second transverse beam section 12. The bridging rod 71 is movable to move forward and backward in the length direction L of the reflow soldering oven. When the bridging rod 71 moves to the second transverse beam section 12 and is received by the receiving structure 72, the bridging device 7 bridges the first transverse beam section 11 and the second transverse beam section 12 so as to align the first conveyor section 21 with the second conveyor section 22 shown in Fig. 2. The receiving structure 72 is, for example, a receiving seat provided with a receiving hole 721, and the bridging rod 71 can be received in the receiving hole 721.

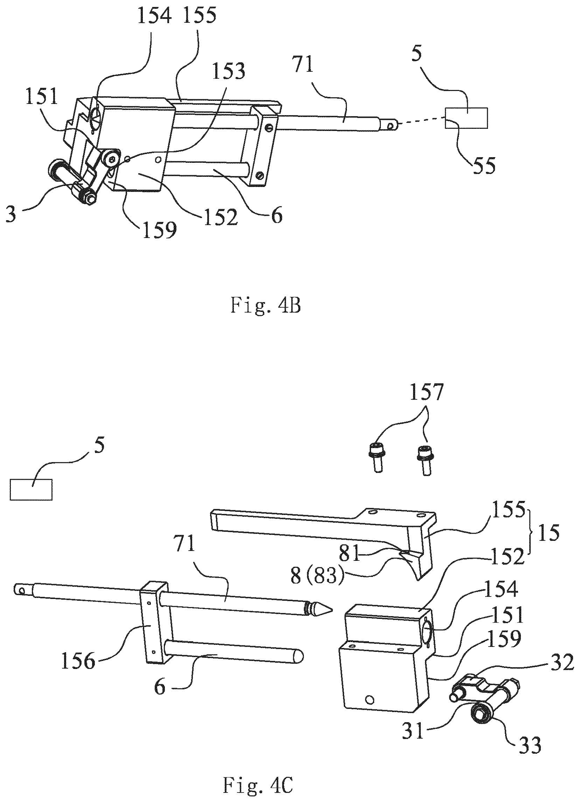

Fig. 4A is an assembled perspective view of the support device 3 and associated components, Fig. 4B is an assembled perspective view of the support device 3 and the associated components from another perspective, and Fig. 4C is an exploded view of the support device 3 and the associated components.

As shown in Figs. 4A-4C, and in particular in Fig. 4C, the support device 3 includes a support block 32 and a support roller 33, where a proximal end of the support block 32 is rotatably coupled to the frame 1. The support roller 33 is disposed at a distal end of the support block 32 and is rotatably connected to the support block 32. An outer peripheral surface of the support roller 33 forms the supporting surface 31. When the electronic substrate is supported, the support roller 33 can roll, such that the friction between the supporting surface 31 and the electronic substrate is small. In other embodiments, the support device 3 may also be provided with no support roller, and the supporting surface can be formed by a smooth flat surface of the distal end of the support block 32.

As still shown in Figs. 4A-4C, in order to couple the support device 3 to the frame 1, a mounting base 15 is provided as a part of the frame 1. The mounting base 15 is arranged close to the first conveyor section 21 as shown in Fig. 2 and is connected to the first transverse beam section 11 shown in Figs. 3A and 3B. In order to drive the movement of the support device 3 between the supporting position and the rest position, a drive device 5 and a push rod 6 are provided. The push rod 6 and the bridging rod 71 share the same drive device 5. The push rod 6 and the bridging rod 71 are arranged side by side in the height direction H of the reflow soldering oven. The push rod 6 is shorter than the bridge 71 and is connected to the bridge 71 by a rod connecting block 156. The drive device 5 includes an output end 55 which is connected to the bridging rod 71. The drive device 5 can drive the bridging rod 71 to move forward or backward linearly, thereby simultaneously driving the push rod 6 linearly.

In some embodiments of the present disclosure, the drive device 5 is a cylinder which can provide a linear driving force to drive the bridging rod 71 and the push rod 6 to move linearly. The bridging rod 71 has a long length such that the drive device 5 can be arranged at one end of the reflow soldering oven, for example outside a hearth thereof, so as to prevent the effects from high temperature. Such an arrangement allows the drive device 5 to operate normally at high hearth temperature. In other embodiments, the drive device 5 may also be other power device that provides a linear driving force, such as an electric motor. In addition, in other embodiments, the drive device 5 may also be connected to the push rod 6 and drive the push rod 6 to move, the push rod 6 in turn drives the bridging rod 71 to move.

The mounting base 15 includes a mounting base body 152 and a lateral additional block 155 that are connected by fasteners 157. An accommodating portion 159 is provided on a side of the mounting base body 152, the support device 3 is rotatably connected to the mounting base body 152 at the proximal end thereof and is located at least partially in the accommodating portion 159. A top of the accommodating portion 159 forms a stop structure 151 to limit a distance by which the support device 3 rotates upwardly. The mounting base 15 is provided with a first guide hole 153 and a second guide hole 154 (see Fig. 4B) extending along the length direction L of the reflow soldering oven, where the first guide hole 153 and the second guide hole 154 receive the push rod 6 and the bridging rod 71, respectively, and guide the push rod 6 and the bridging rod 71 to move forward and backward in the conveying direction of the electronic substrate. One end of the first guide hole 153 is disposed at the accommodating portion 159, and one end of the push rod 6 projects through the first guide hole 153 into the accommodating portion 159 to push the support device 3 to rotate. An additional support structure 8 is formed on the lateral additional block 155 close to the first conveyor section. The additional support structure 8 includes a supporting flange 83 including an additional supporting surface 81 for providing additional support for the electronic substrate conveyed between the first conveyor section 21 and the second conveyor section 22. In the embodiments shown, when the support device 3 is in its supporting position, the additional supporting surface 81 is located between the first conveying surface of the first conveyor section (not shown in Figs. 4A-4C) and the supporting surface 31 of the support device 3 and is substantially flush with the supporting surface 31.

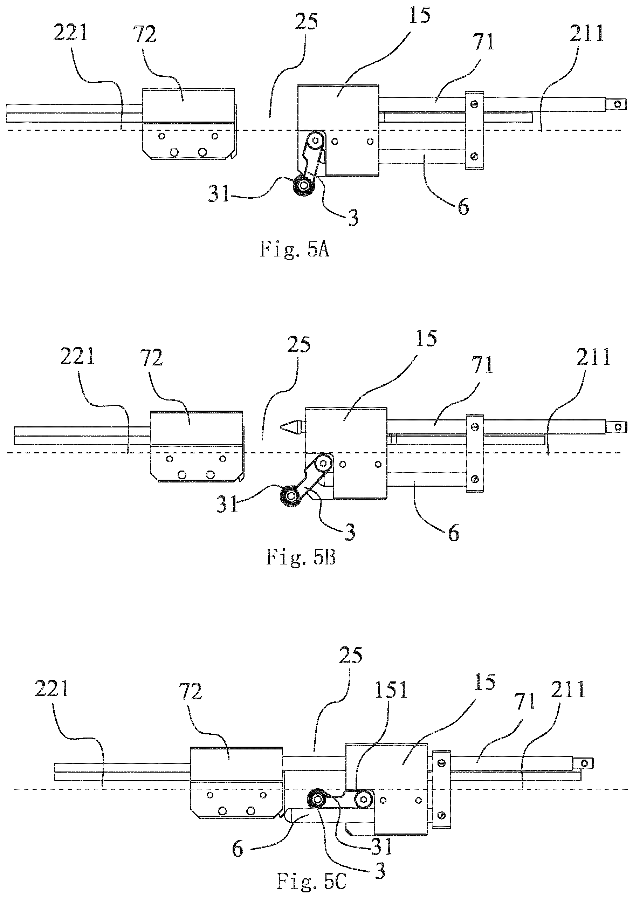

Fig. 5A is a side view of the support device 3 in the rest position, Fig. 5B is a side view of the support device 3 rotated a certain distance from the rest position shown in Fig. 5A, and Fig. 5C is a side view of the support device 3 in the supporting position. Figs. 5A-5C show the movement of the support device 3.

When it is desired to activate the vacuum treatment zone 9 of the reflow soldering oven, it is required to place the cover 92 in its closed state such that the side wall 922 of the cover 92 is located in the receiving area 25 between the first conveyor section 21 and the second conveyor section 22. To this end, it is required to place the support device 3 in the rest position as shown in Fig. 5A. As shown in Fig. 5A, when the support device 3 is in the rest position, the push rod 6 and the bridging rod 71 are retracted by the drive device 5 (as shown in Fig. 4A) and the support device 3 is located outside the receiving area 25. The supporting surface 31 of the support device 3 is located below a plane in which the first conveying surface 211 and the second conveying surface 221 are located (see the dashed line).

When it is desired to convey the electronic substrate between the first conveyor section 21 and the second conveyor section 22, the cover 92 is in its open state and the support device 3 is driven by the drive device to the supporting position as shown in Fig. 5C.

During being driven from the rest position shown in Fig. 5A to the supporting position shown in Fig. 5C, as shown in Fig. 5B, the drive device drives the bridging rod 71 to move toward the receiving structure 72 and simultaneously drive the push rod 6 to move toward the support device 3. The push rod 6 pushes the support device 3 to rotate in a clockwise direction as shown and gradually enters the receiving area 25. As the support device 3 moves, the supporting surface 31 of the support device 3 gradually approaches the plane in which the first conveying surface 211 and the second conveying surface 221 are located.

As shown in Fig. 5C, when the support device 3 is in the supporting position, the support device 3 partially enters the receiving area 25 and the supporting surface 31 is substantially flush with the plane in which the first conveying surface 211 and the second conveying surface 221 are located. The bridging rod 71 enters the receiving structure 72. The support device 3 is restricted by the stop structure 151 from further rotating in the clockwise direction, to prevent the supporting surface 31 from moving above the plane in which the first conveying surface 211 and the second conveying surface 221 are located. In addition, the support device 3 is held in the supporting position by the drive device and the push rod 6 and cannot be rotated in a counter-clockwise direction toward its rest position. Thereby, the supporting surface 31 of the support device 3 can support the electronic substrate conveyed between the first conveying surface 211 and the second conveying surface 221, so as to improve the stability of the electronic substrate during conveying.

When the support device 3 is required to return from the supporting position shown in Fig. 5C to the rest position shown in Fig. 5A, the drive device drives the bridging rod 71 and the push rod 6 to move backward, the support device 3 can be rotated away from the receiving area 25 in the counter-clockwise direction as shown by gravity or by the pushing of the side wall 922 of the cover 92 back to the rest position as shown in Fig. 5A.

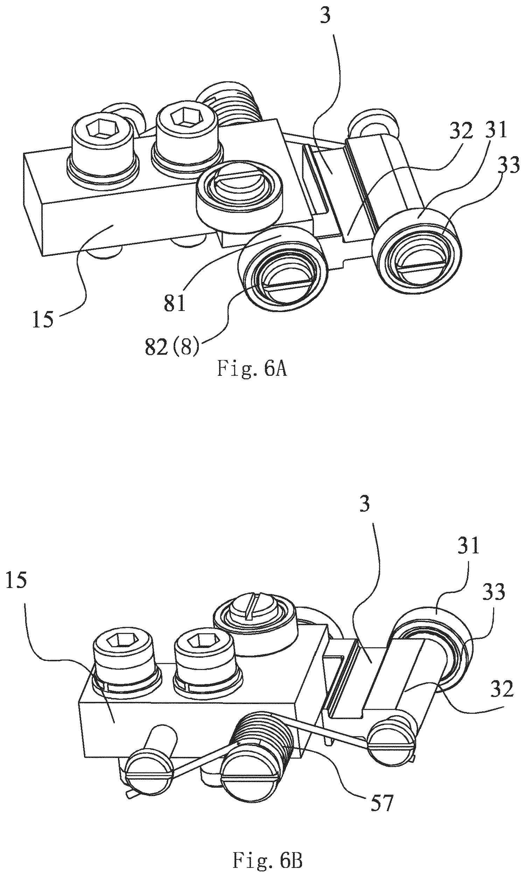

Fig. 6A is a perspective view of the support device 3 and the associated components of the reflow soldering oven according to a second embodiment of the present disclosure, and Fig. 6B is a perspective view of the support device 3 and the associated components shown in Fig. 6A from another perspective. The reflow soldering oven in the embodiment shown in Figs. 6A and 6B is substantially similar to the reflow soldering oven in the embodiment shown in Figs. 1A-2, except that the configuration of the drive device and the configuration of the additional support structure are different.

As shown in Figs. 6A and 6B, the reflow soldering oven also includes a mounting base 15 and a support device 3 which is coupled to the frame by the mounting base 15. The support device 3 is rotatably mounted to the mounting base 15 to move between the supporting position and the rest position. The support device 3 includes a support block 32 and a support roller 33, where an outer peripheral surface of the support roller 33 forms a supporting surface 31.

As shown in Fig. 6B, in this embodiment, the drive device for driving the support device 3 is formed by an elastic device 57. The elastic device 57 is, for example, a torsion spring. The elastic device 57 is disposed between the support device 3 and the mounting base 15. The elastic device 57 drives the support device 3 to rotate from the rest position to the supporting position and hold the support device 3 in the supporting position by a spring force. Also, when the support device 3 is pushed downward by the cover during the closure of the cover, the spring device 57 can be biased to allow the support device 3 to rotate back to the rest position.

In addition, as shown in Fig. 6A, in this embodiment, the additional support structure 8 is formed by an additional support roller 82. The additional support roller 82 is rotatably connected to the mounting base 15 and an outer peripheral surface of the additional support roller 82 forms an additional supporting surface 81. When the support device 3 is in its supporting position, the additional supporting surface 81 is located between the first conveying surface (not shown in Figs. 6A and 6B) of the first conveyor section and the supporting surface 31 of the support device 3 and is substantially flush with the supporting surface 31 to provide additional support for the electronic substrate conveyed between the first conveyor section and the second conveyor section.

In the embodiment shown in Figs. 6A and 6B, the bridging device 7, as well as a drive device for driving the bridge rod 71, such as a cylinder, may also be provided.

According to the reflow soldering oven of the present disclosure, the movable support device is provided and is allowed to enter and exit the receiving area between the adjacent conveyor sections for the cover, such that when it is desired to mount the cover between the adjacent conveyor sections, the support device can exit the receiving area between the conveyor sections to allow the cover to enter the receiving area, and when it is desired to convey the electronic substrate between adjacent conveyor sections, the support device can enter the receiving area between the conveyor sections to support the electronic substrate by its supporting surface. The stability of conveying of the electronic substrate can be improved because the support device can provide support when the electronic substrate is conveyed between the adjacent conveyor sections.

Although the present disclosure is described with respect to the examples of embodiments outlined above, various alternatives, modifications, variations, improvements, and/or substantial equivalents that are known or current or to be anticipated before long may be obvious to those of at least ordinary skill in the art. In addition, the technical effects and/or technical problems described in this specification are exemplary rather than limiting; Therefore, the disclosure in this specification may be used to solve other technical problems and have other technical effects and/or may solve other technical problems. Accordingly, the examples of the embodiments of the present disclosure as set forth above are intended to be illustrative rather than limiting. Various changes can be made without departing from the spirit or scope of the present disclosure. Therefore, the present disclosure is intended to include all known or earlier developed alternatives, modifications, variations, improvements and/or basic equivalents.

## Claims

1. An apparatus for joining electronic components to an electronic substrate, comprising:
a frame (1);
a first conveyor section (21) and a second conveyor section (22) supported by the frame (1) and arranged spaced apart from each other along a conveying direction of the electronic substrate, and the first conveyor section (21) and the second conveyor section (22) having a first conveying surface (211) and a second conveying surface (221), respectively, wherein a receiving area (25) is provided between the first conveyor section (21) and the second conveyor section (22); and
a support device (3) coupled to the frame (1) and movable between a supporting position and a rest position relative to the first conveyor section (21) and the second conveyor section (22), the support device (3) having a supporting surface (31);
wherein in the supporting position, the support device (3) is at least partially located and held in the receiving area (25) and the supporting surface (31) is substantially flush with the first conveying surface (211) and the second conveying surface (221); and
wherein in the rest position, the support device (3) exits the receiving area (25).

2. The apparatus of claim 1, wherein
the support device (3) comprises a support block (32) rotatably coupled to the frame (1) and a support roller (33) rotatably connected to the support block (32), wherein the supporting surface (31) is formed by the support roller (33).

3. The apparatus of claim 2, further comprising:
a stop structure (151) provided on the frame (1) and above the support block (32), wherein when the support block (32) is rotated to the supporting position, the support block (32) is stopped by the stop structure (151).

4. The apparatus of claim 3, further comprising:
a drive device (5) configured to drive the support device (3) to move from the rest position to the supporting position, maintain the support device (3) in the supporting position and allow the support device (3) to move from the supporting position to the rest position.

5. The apparatus of claim 4, wherein
the drive device (5) provides a linear driving force and comprises an output end (55); and
the apparatus further comprises a push rod (6) connected to the output end (55) of the drive device (5) and configured to travel forward and backward under the drive of the drive device (5);
wherein when the push rod (6) travels forward, the push rod (6) pushes the support device (3) to rotate from the rest position to the supporting position, and when the push rod (6) travels backward, the push rod (6) allows the support device (3) to rotate from the supporting position to the rest position.

6. The apparatus of claim 5, wherein
the frame (1) comprises a first transverse beam section (11) and a second transverse beam section (12) arranged spaced apart from each other along the conveying direction of the electronic substrate and supporting the first conveyor section (21) and the second conveyor section (22), respectively.

7. The apparatus of claim 6, further comprising:
a bridging device (7) comprising a bridging rod (71) and a receiving structure (72), the bridging rod (71) being connected to the output end (55) of the drive device (5) and configured to travel forward and backward under the drive of the drive device (5), and the receiving structure (72) being disposed at the second transverse beam section (12) and configured to receive the bridging rod (71).

8. The apparatus of claim 7, wherein
the frame (1) comprises a mounting base (15) to which the support block (32) is rotatably connected, the stop structure (151) being provided on the mounting base (15);
wherein the mounting base (15) is provided with a first guide hole (153) and a second guide hole (154) receiving the push rod (6) and the bridging rod (71), respectively, and guiding the push rod (6) and the bridging rod (71) to travel forward and backward in the conveying direction.

9. The apparatus of claim 1, further comprising:
an additional support structure (8) having an additional supporting surface (81), wherein when the support device (3) is in the supporting position, the additional supporting surface (81) is located between the supporting surface (31) of the support device (3) and the first conveying surface (211) or the second conveying surface (221), and the additional supporting surface (81) is substantially flush with the supporting surface (31).

10. The apparatus of claim 9, wherein
the additional support structure (8) comprises an additional support roller (82) rotatably coupled to the frame (1), the additional supporting surface (81) being formed by the additional support roller (82); or
the additional support structure (8) comprises a supporting flange (83) provided on a side of the frame (1), the additional supporting surface (81) being formed by the supporting flange (83).

11. An apparatus for joining electronic components to an electronic substrate, comprising:
a frame (1);
a vacuum treatment zone (9) comprising:
a base (91) supported by the frame (1);
a first conveyor section (21) supported by the frame (1) and having a first conveying surface (211); and
a cover (92) having a side wall (922) and having a closed state and an open state;
a second conveyor section (22) supported by the frame (1) and arranged spaced apart from the first conveyor section (21) along a conveying direction of the electronic substrate, the second conveyor section (22) having a second conveying surface (221), wherein a receiving area (25) is provided between the first conveyor section (21) and the second conveyor section (22); and
a support device (3) coupled to the frame (1) and movable between a supporting position and a rest position relative to the first conveyor section (21) and the second conveyor section (22), the support device (3) having a supporting surface (31);
wherein when the vacuum treatment zone (9) is activated, the cover (92) is in the closed state, the support device (3) is in the rest position, the side wall (922) of the cover (92) is located in the receiving area (25) and engaged with the base (91) to form a chamber (93) between the cover (92) and the base (91), and the first conveyor section (21) is accommodated in the chamber (93); and
wherein when the electronic substrate is conveyed between the vacuum treatment zone (9) and the second conveyor section (22), the cover (92) is in the open state, the support device (3) is in the supporting position, the side wall (922) of the cover (92) exits the receiving area (25) while the support device (3) is at least partially located and held in the receiving area (25), and the supporting surface (31) is substantially flush with the first conveying surface (211) and the second conveying surface (221), such that the electronic substrate is at least partially supported by the supporting surface (31) as the electronic substrate is conveyed between the first conveying surface (211) and the second conveying surface (221).

12. The apparatus of claim 11, wherein
the support device (3) comprises a support block (32) rotatably coupled to the frame (1) and a support roller (33) rotatably connected to the support block (32), wherein the supporting surface (31) is formed by the support roller (33).

13. The apparatus of claim 12, further comprising:
a stop structure (151) provided on the frame (1) and above the support block (32), wherein when the support block (32) is rotated to the supporting position, the support block (32) is stopped by the stop structure (151).

14. The apparatus of claim 12, further comprising:
a drive device (5) configured to drive the support device (3) to move from the rest position to the supporting position, maintain the support device (3) in the supporting position and allow the support device (3) to move from the supporting position to the rest position.

15. The apparatus of claim 14, wherein
the drive device (5) provides a linear driving force and comprises an output end (55); and
the apparatus further comprises a push rod (6) connected to the output end (55) of the drive device (5) and configured to travel forward and backward under the drive of the drive device (5);
wherein when the push rod (6) travels forward, the push rod (6) pushes the support device (3) to rotate from the rest position to the supporting position, and when the push rod (6) travels back, the push rod (6) allows the support device (3) to rotate from the supporting position to the rest position.
